# NOUVEAU FASCICULE DE BREVET EUROPEEN

(11) **EP 1 004 369 B2**
(45) Date de publication et mention de la décision concernant l'opposition: **12.11.2008**
(45) Mention de la délivrance du brevet: 02.06.2004
(21) Numéro de dépôt: 98870258.5
(22) Date de dépôt: 26.11.1998
(51) Int. Cl.: B21B 45/00, C23C 14/56

(54) **Sas d'étanchéité pour chambre à vide**
Abgedichtete Schleuse für eine Vakuumkammer
Sealing lock for a vaccum chamber

(43) Date de publication de la demande: 31.05.2000
(73) Titulaire: ArcelorMittal France, 93200 Saint-Denis (FR)
(72) Inventeur: Vanden Brande, Pierre, 1040 Bruxelles (BE); Weymeersch, Alain, 1300 Wavre (BE)
(74) Mandataire: Leherte, Georges M.L.M.

(56) Documents cités:
- EP-A- 0 293 929
- EP-A- 0 388 811
- EP-A- 0 652 302
- EP-B- 0 337 369
- EP-B- 0 527 859
- EP-B- 0 668 370
- DD-A- 289 297
- US-A- 2 972 330
- US-A- 3 868 106

## Description

La présente invention est relative à un sas d'étanchéité pour l'introduction et le passage en continu d'une bande d'un substrat, telle qu'une tôle, dans une chambre à vide, comprenant
- une enceinte,
- au moins deux premiers rouleaux montés dans l'enceinte de manière à tourner autour d'axes parallèles,
- au moins un deuxième rouleau monté dans l'enceinte de manière à tourner autour d'un axe parallèle aux axes desdits au moins deux premiers rouleaux,
- un passage prévu pour le déplacement de la bande entre, successivement dans la direction de déplacement de la bande, un desdits au moins deux premiers rouleaux, un deuxième rouleau et un autre desdits au moins deux premiers rouleaux, lesdits au moins deux premiers rouleaux étant situés d'un côté du passage et ledit au moins un deuxième rouleau du côté opposé à ce passage, et
- des moyens pour régler la distance entre au moins deux rouleaux successifs.
(voir par exemple US-A-368106 et EP 0293929)

On connaît aussi des sas d'étanchéité à chambres à vide successives, multiples à l'entrée et à la sortie de l'enceinte (voir par exemple US-A-2.972.330).

Un des buts de l'invention est de présenter un sas du type précité permettant d'atteindre à la fois un encombrement minimal et une étanchéité maximale pour le passage en continu d'une bande d'un substrat.

Pour résoudre ce problème, on a prévu suivant l'invention un sas d'étanchéité selon la revendication 1.

D'autres formes de réalisation de l'invention sont indiquées dans les revendications dépendantes.

D'autres détails et particularités de l'invention ressortiront de la description, donnée ci-après, à titre d'exemples de deux formes de réalisation particulières du sas d'étanchéité suivant l'invention avec référence aux dessins annexés.
La figure 1 est une vue schématique d'une coupe longitudinale d'une première forme de réalisation du sas d'étanchéité suivant l'invention.
La figure 2 est une coupe suivant la ligne II-II de la figure 1.
La figure 3 est une vue en plan suivant la ligne III-III de la figure 1.
La figure 4 est une vue en coupe analogue à la figure 1 d'une deuxième forme de réalisation du sas suivant l'invention.

Dans les différentes figures, les mêmes chiffres de référence concernent les mêmes éléments ou des éléments analogues.

D'une façon générale, l'invention concerne un sas d'étanchéité destiné à être agencé en amont de l'entrée et en aval de la sortie d'une chambre à vide qui est traversée d'une manière continue par une bande d'un substrat, notamment d'une tôle d'acier.

Les deux sas peuvent être identiques ou différents en fonction de l'importance du vide devant être maintenu dans la chambre susdite.

Dans chacun de ces sas sont montés des rouleaux pouvant tourner librement autour de leurs axes qui s'étendent transversalement par rapport à la direction de déplacement de la bande et parallèlement les uns aux autres.

Ces sas sont caractérisés par le fait que les rouleaux sont décalés l'un par rapport à l'autre dans la direction de déplacement de la bande.

Avantageusement, l'enceinte d'un sas comprend au moins trois rouleaux successifs décalés suivant la direction de déplacement de la bande et entre lesquels est prévu un passage pour cette dernière.

Les premier et troisième rouleaux sont situés d'un côté de ce passage ou de la bande se déplaçant à travers de ce dernier, tandis que le deuxième rouleau est situé du côté opposé de ce passage ou de la bande par rapport aux deux rouleaux précédents et ceci d'une manière telle à former une zone sensiblement étanche entre cette bande et les premier et troisième rouleaux.

Pour maintenir une dépression dans cette zone, celle-ci est raccordée à une pompe à vide et des moyens sont prévus pour régler la pression de la bande sur les rouleaux en fonction des différences de pression existant entre cette zone et l'environnement de cette dernière.

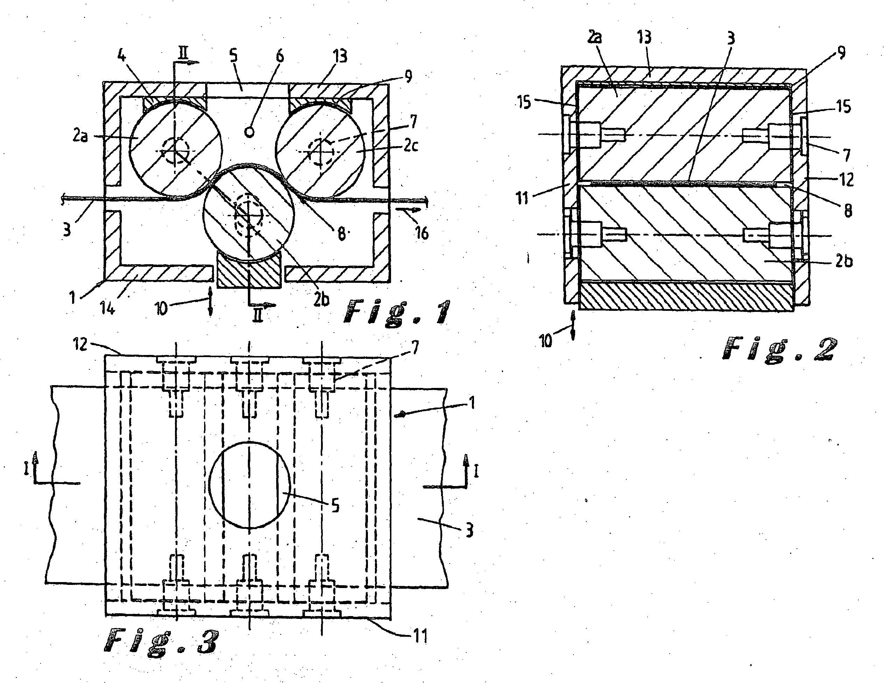

Les figures 1 à 3 montrent schématiquement une première forme de réalisation particulière d'un sas d'étanchéité suivant l'invention.

Ce sas est constitué d'un boîtier parallélépipèdique 1 délimitant une enceinte dans laquelle sont agencés trois rouleaux 2a, 2b et 2c d'axes horizontaux et parallèles disposés avec un décalage horizontal et de manière à former entre deux rouleaux consécutifs un passage 9 dans lequel est guidée une tôle continue 3.

Les rouleaux 2a et 2c sont agencés au-dessus de ce passage 9, tandis que le rouleau intermédiaire 2b se trouve entre les deux rouleaux 2a et 2c en dessous de ce passage. Ces trois rouleaux forment donc des rouleaux successifs, c'est-à-dire décalés dans la direction de déplacement de la bande 3, indiqué par la flèche 16. Ainsi, une zone 6 est formée entre ces rouleaux, les parois latérales 11 et 12 du boîtier 1 et la bande 3. L'étanchéité de cette zone est assurée en prévoyant un jeu minimal entre les parois latérales 11 et 12 du boîtier 1 et les rouleaux 2a, 2b et 2c ainsi que par des éléments d'étanchéité 4 entre les parois cylindriques des rouleaux et les parois supérieure 13 et inférieure 14 du boîtier 1. La tôle 3 assure l'étanchéité principale entre deux rouleaux successifs en se déplaçant avec une pression déterminée contre une partie de la surface cylindrique de ces derniers.

La seule fuite relativement importante a lieu aux fentes 8 subsistant entre les bords latéraux de la tôle 3 et les parois latérales 11 et 12 du boîtier.

Pour maintenir une fuite minimale entre les deux faces planes d'extrémité 15 des rouleaux 2a, 2b, 2c et les parois latérales 11 et 12 du boîtier 1, ces rouleaux sont montés en rotation autour de paliers 7 agencés à l'intérieur des extrémités de ces rouleaux 2.

Pour compenser ces fuites, qui sont inévitables, cette zone 6 est branchée sur une pompe à vide, non représentée, par une ouverture 5 prévue dans la paroi supérieure 13 du boîtier 1.

Avantageusement, dans la forme de réalisation particulière représentée aux figures 1 à 3, les paliers 7 du rouleau 2b sont montés de manière à pouvoir subir un léger déplacement vertical dans les parois latérales 11 et 12. Il en est de même pour l'élément d'étanchéité 4 coopérant avec la surface cylindrique de ce rouleau 2b qui peut être monté à coulissement vertical, comme montré par les flèches 10, dans la .paroi inférieure 14 du boîtier 1. De cette façon, il est possible de régler la distance entre deux rouleaux successifs et ainsi la section du passage 9 entre ces rouleaux en fonction de l'épaisseur de la tôle 3.

Le diamètre des rouleaux 2a, 2b et 2c, qui est généralement identique pour les trois rouleaux, est suffisamment important pour ne pas induire des déformations plastiques dans la tôle 3. Avantageusement, pour une tôle d'une épaisseur de 1 mm, ce diamètre est au moins de 600 mm.

Par ailleurs, pour assurer l'étanchéité de la zone 6, il est important que la pression de contact entre la tôle et les rouleaux servant à l'étanchéité entre cette zone égalise au moins la différence de pression entre celle régnant dans cette dernière et son environnement. Ainsi, pour une différence de pression de 500 mbar et un rouleau d'un diamètre de 600 mm et une bande de 1 m de largeur, la traction à exercer sur la tôle dans le sens de déplacement indiqué par la flèche 16 est avantageusement au moins de 3000 kg, ce qui, pour une tôle d'une épaisseur de 1 mm, correspond à une traction de 3 kg par mm². Pour une tôle de même largeur et d'épaisseur de 0,5 mm, on passe ainsi à une traction de 6 kg par mm². Si la traction limite est par exemple de 6 kg par mm², une tôle de 0,25 mm n'assure l'étanchéité que pour une différence de pression maximale limitée à 250 mbar.

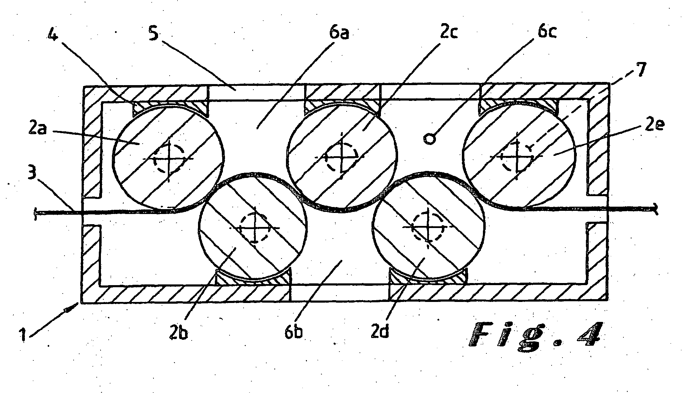

La figure 4 concerne une deuxième forme de réalisation du sas d'étanchéité suivant l'invention qui se distingue par rapport à la précédente par le fait que le boîtier 1 comprend une succession de trois zones 6a, 6b et 6c sensiblement étanches, qui sont obtenues en prévoyant dans le boîtier 1 cinq rouleaux consécutifs se situant alternativement d'un côté et de l'autre côté de la bande 3.

Ainsi, si, comme mentionné en rapport avec la première forme de réalisation précitée, la traction limite est par exemple de 6 kg par mm², une tôle de 0,25 mm n'assure l'étanchéité désirée que pour une différence de pression maximale entre deux zones successives de cette deuxième forme de réalisation qui est limitée à 250 mbar. Ceci exige donc deux zones supplémentaires dans le boîtier, ce qui est donc obtenu en augmentant le nombre de rouleaux successifs s'étendant alternativement d'un côté et de l'autre côté de la bande.

II est bien entendu que l'invention n'est pas limitée aux formes de réalisation décrites ci-dessus et illustrées par les figures annexées d'un sas d'étanchéité, mais que d'autres variantes peuvent être envisagées, notamment en ce qui concerne le nombre de rouleaux, la disposition relative de ces derniers ainsi que les moyens prévus éventuellement pour régler la distance entre deux rouleaux successifs et ceux pour assurer l'étanchéité entre les parois du boîtier et les rouleaux, sans sortir du cadre de l'invention tel que defini par les revendications annexées.

De plus, lorsque l'épaisseur des tôles à traiter est relativement importante par rapport à leur largeur, dans certains cas, il pourrait être utile de prévoir des moyens d'étanchéité supplémentaires agencés dans les fentes 8 entre deux rouleaux successifs de part et d'autre des bords latéraux de la tôle.

## Revendications

1. Sas d'étanchéité pour l'introduction et le passage en continu d'une bande d'un substrat (3), telle qu'une tôle, dans une chambre à vide, comprenant
- une enceinte,
- au moins deux premiers rouleaux (2a, 2c) montés dans l'enceinte de manière à tourner autour d'axes parallèles,
- au moins un deuxième rouleau (2b) monté dans l'enceinte de manière décalée par rapport audits au moins deux premiers rouleaux (2a, 2c) de manière à tourner autour d'un axe parallèle aux axes desdits au moins deux premiers rouleaux (2a, 2c),
- un passage prévu pour le déplacement de la bande entre, successivement dans la direction de déplacement de la bande, un desdits au moins deux premiers rouleaux (2a), un deuxième rouleau (2b) et un autre desdits au moins deux premiers rouleaux (2c), lesdits au moins deux premiers rouleaux (2a, 2c) étant situés d'un côté du passage et ledit au moins un deuxième rouleau (2b) du côté opposé à ce passage, et
- une zone entre la bande (3) et lesdits deux premiers rouleaux (2a, 2c) successifs, raccordée à une pompe à vide,
- des moyens pour régler la distance entre au moins deux rouleaux successifs (2a, 2b) ou (2b, 2c), et
**caractérisé en ce qu'** une zone sensiblement étanche (6; 6a, 6b, 6c) est formée entre la bande (3), lesdits au moins deux premiers rouleaux (2a, 2c), les parois latérales (11) et (12) de l'enceinte, ainsi que des éléments d'étanchéité (4) entre les parois cylindriques des rouleaux et les parois supérieure (13) et inférieure (14) de l'enceinte, et
**en ce que** le sas comprend en outre d'autres moyens pour régler la pression de la bande (3) sur les rouleaux (2a, 2c) en fonction des différences de pression existant entre ladite zone sensiblement étanche (6; 6a; 6b; 6c) et l'environnement de ladite zone (6; 6a; 6b; 6c).

2. Sas suivant la revendication 1, **caractérisé en ce que** lesdits moyens pour régler la distance règlent celle-ci suivant une direction (10) sensiblement perpendiculaire à la direction de déplacement (16) de la bande (3).

3. Sas suivant l'une ou l'autre des revendications 1 ou 2, **caractérisé en ce que** des moyens sont prévus pour mettre la bande (3) sous une traction telle que cette dernière puisse reprendre la différence de pression existant entre deux zones consécutives (6).

4. Sas suivant l'une quelconque des revendications 1 à 3, **caractérisé en ce que** les moyens de réglage de distance ajustent la section du passage (9) susdit entre rouleaux, en fonction de l'épaisseur de la bande.

## Claims

1. An air lock for introducing and continuously passing a strip of substrate (3), such as a metal sheet, through a vacuum chamber, comprising :
- an enclosure;
- at least two first rollers (2a, 2c) mounted in the enclosure, so as to rotate about parallel axes;
- at least one second roller (2b) mounted in the enclosure so as to rotate about an axis parallel to said axes of said at least two first roller (2a, 2c);
- a passage provided for the travel of the strip between, successively in the direction of travel of the strip, one of said at least two first rollers (2a), a second roller (2b) and another of said at least two first rollers (2c), said at least two first rollers (2a, 2c) being situated on one side of the passage and said at least one second roller (2b) on the opposite side of said passage;
- a region formed between the strip (3) and said two first successive rollers (2a, 2b), this region being connected to a vacuum pump;
- means provided for adjusting the distance between at least two successive rollers (2a, 2b) or (2b, 2c), and
**characterized in that** an essentially airtight region (6; 6a, 6b, 6c) is formed between the strip (3) and said two first rollers (2a, 2b), the side walls (11) and (12) of the enclosure, as well as sealing members (4) between the cylindrical walls of the rollers and the upper (13) and lower (14) walls of the enclosure,
**and in that** the air lock further comprises other means provided for adjusting the pressure of the strip (3) on the rollers (2a, 2c) in function of the pressure difference existing between this essentially airtight region (6; 6a, 6b, 6c) and the surroundings of this region (6; 6a, 6b, 6c).

2. Air lock according to claim 1, **characterized in that** said means for adjusting the distance adjust it in a direction (10) which is substantially perpendicular to the direction of travel (16) of the strip (3).

3. Air lock according to claims 1 or 2, **characterized in that** means are provided for placing the strip (3) under a tension such that the strip can absorb the difference in pressure that there is between two consecutive regions (6).

4. Air lock according to any one of claims 1 to 3, **characterized in that** said means for adjusting the distance adjust the cross section of said passage (9) between rollers according to the thickness of the strip.

## Patentansprüche

1. Abgedichtete Schleuse zum Einführen und kontinuierlichen Hindurchbewegen eines Bandes eines Substrats (3), beispielsweise eines Blechs, in eine Vakuumkammer, umfassend
- eine Kammer,
- mindestens zwei erste Walzen (2a, 2c), die in der Kammer derart angeordnet sind, daß sie sich um parallele Achsen drehen können,
- mindestens eine zweite Walze (2b), die in der Kammer versetzt in Bezug auf die mindestens zwei ersten Walzen (2a, 2c) angeordnet ist, derart dass sie sich um eine Achse, die zu den Achsen der mindestens zwei ersten Walzen (2a, 2c) parallel ist, drehen kann,
- einen für die Bewegung des Bandes vorgesehenen Durchiaß zwischen, nacheinander in der Bewegungsrichtung des Bandes, einer der mindestens zwei ersten Walzen (2a), einer zweiten Walze (2b) und einer weiteren der mindestens zwei ersten Walzen (2c), wobei die mindestens zwei ersten Walzen (2a, 2c) auf der eine Seite des Durchlasses angeordnet sind und die mindestens eine zweite Walze (2b) auf der entgegengesetzten Seite dieses Durchlasses angeordnet ist,
- eine dichte Zone, zwischen dem Band (3) und den zwei aufeinanderfolgenden ersten Walzen (2a, 2c), die mit einer Vakuumpumpe verbunden is,
- Mittel zum Einstellen der Distanz zwischen mindestens zwei aufeinanderfolgenden Walzen (2a, 2b) oder (2b, 2c), und
**dadurch gekennzeichnet, daß** eine im wesentlichen dichte Zone (6; 6a, 6b, 6c) zwischen dem Band (3) und den zwei ersten Walzen (2a, 2c) , den Seitenwänden (11) und (12) der Kammer, sowie Dichtungselemente (4) zwischen den zylindrischen Wänden der Walzen und der oberen (13) und unteren (14) Wand der Kammer ausgebildet ist,
**und dadurch, daß** die Schleuse ferner umfasßt weitere Mittel zum Einstellen des Drucks des Bandes (3) auf die Walzen (2a, 2c) entsprechend der Druckdifferenzen die zwischen diese im wesentliche dichte Zone (6; 6a, 6b, 6c) und die Umgebung dieser Zone (6; 6a, 6b, 6c) besteht.

2. Schleuse nach Anspruch 1, **dadurch gekennzeichnet, daß** die Mittel zum Einstellen der Distanz dieselbe längs einer zu der Bewegungsrichtung (16) des Bandes (3) im wesentlichen senkrechten Richtung (10) einstellen.

3. Schleuse nach einem der Ansprüche 1 oder 2, **dadurch gekennzeichnet, daß** Mittel vorgesehen sind, um das Band (3) mit einem solchen Zug zu beaufschlagen daß dieses letztere die zwischen zwei aufeinanderfolgende Zonen (6) existierende Druckdifferenz aufnehmen kann.

4. Schleuse nach einem der Ansprüche 1 bis 3, **dadurch gekennzeichnet, daß** Mittel zum Einstellen der Distanz den Querschnitt des vorstehend genannten Durchlasses (9) zwischen den Walzen in Abhängigkeit von der Dicke des Banden anpassen.
